# EUROPEAN PATENT SPECIFICATION

(11) **EP 1 204 165 B1**
(45) Date of publication and mention of the grant of the patent: **28.06.2006**
(21) Application number: 01124344.1
(22) Date of filing: 22.10.2001
(51) Int. Cl.: H01R 11/28, H01R 13/66

(54) **A battery terminal provided with a current sensor**
Batterieklemme mit Stromsensor
Cosse de connection pour batterie avec mesureur de courant

(30) Priority: 01.11.2000 JP 2000335032
(43) Date of publication of application: 08.05.2002
(73) Proprietor: Sumitomo Wiring Systems, Ltd., Yokkaichi-City, Mie, 510-8503 (JP)
(72) Inventor: Wakata, Shigekazu, Sumitomo Wiring Systems, Ltd., Yokkaichi-City, Mie 510-8503 (JP); Wakui, Masanori, Toyota-shi, Aichi-ken 471-8572 (JP); Niwa, Hisao, Toyota-shi, Aichi-ken 471-8572 (JP); Okubo, Naohiko, Toyota-shi, Aichi-ken 471-8572 (JP)
(74) Representative: Müller-Boré & Partner Patentanwälte

(56) References cited:
- FR-A- 2 293 073
- FR-A- 2 702 310

## Description

The present invention relates to a battery terminal to be provided with a current sensor.

The kinds and number of electric parts of a vehicle have recently kept on increasing and, accordingly, electric energy produced by a vehicle battery has been more intensely exhausted. Thus, a demand for monitoring a remaining capacity of the battery has become larger than before. In such a case, a current sensor may be mounted on a battery post and a degree of exhaustion of the battery may be detected depending on the intensity of a current detected thereby.

However, there is no sufficient space to mount the current sensor around the battery post of the existing battery. Even if the current sensor is mounted on a wiring harness to be connected with battery post, there is still a problem that it may be easily broken upon being struck against something in consideration of how the wiring harness is handled.
FR-A-2 293 073 discloses a battery terminal with a current sensor, which is assembled in one piece.

It is the object of the invention to provide a battery terminal to be provided with a current sensor, which allows a excellent mountability of the current sensor.

This object is solved according to the invention by a battery terminal according to claim 1. Preferred embodiments of the invention are subject of the dependent claims.

According to the invention, there is provided a battery terminal to be provided with a current sensor, comprising:
a battery-side terminal to be connected with a battery post,
a harness-side terminal to be connected with the leading end of a wire, preferably of a wiring harness, and
a fastening means for enabling the both terminals to be disconnected from and connected with each other,
wherein a current sensor is to be mounted at a connecting portion where the battery-side terminal and the harness-side terminal are to be connected
wherein the connecting portion is insertable into a slit provided in the sensor.

Accordingly, the current sensor can be mounted using the mutual connecting portion of the battery-side terminal and the harness-side terminal. Since this connecting portion can disconnect and connect the both terminals by means of the fastening means, the current sensor can be connected with the harness-side terminal while directly or indirectly mounted on the battery-side terminal beforehand. Instead of mounting the current sensor beforehand, the current sensor separately prepared may be mounted on the battery-side terminal at the time of connection with the harness-side terminal. In other words, since the current sensor can be mounted without being mounted on a wiring harness, it is free from damage during transportation and handling of the wiring harness.

According to a preferred embodiment of the invention, a mounting portion which serves as the connecting portion with the harness-side terminal extends from the battery-side terminal, and the current sensor is mountable on the mounting portion prior to connection of the both terminals.

Accordingly, the current sensor is mounted on the mounting portion of the battery-side terminal beforehand and is connected with the harness-side terminal in such a state.

Alternatively, a linking member to be coupled by the fastening means is provided between the battery-side terminal and the harness-side terminal, and the current sensor is to be mounted on the linking member.

Accordingly, since the linking member is specially provided to mount the current sensor, existing terminals can be used as the battery-side terminal and the harness-side terminal.

Most preferably, a mounting portion which serves as the connecting portion with the battery side terminal extends from the harness-side terminal, and the current sensor is mountable on the mounting portion prior to connection of the both terminals.

Accordingly, the current sensor is mounted on the mounting portion of the harness-side terminal at the time of connection of the both terminals. Therefore, an existing terminal can be used as the battery-side terminal.

According to a further preferred embodiment, the connecting portion is provided with one or more mounting pieces for connection with the current sensor.

Further preferably, the battery-side terminal is provided with a substantially clamp-like fastening portion to be fastened to a battery post.

These and other objects, features and advantages of the present invention will become more apparent upon reading of the following detailed description of preferred embodiments and accompanying drawings. It should be understood that even though embodiments are separately described, single features thereof may be combined to additional embodiments.
FIG. 1 is an exploded perspective view of a first embodiment,
FIG. 2 is a perspective view showing a state where a current sensor is mounted on a battery-side terminal,
FIG. 3 is a perspective view showing a state of a battery terminal where a harness-side terminal is connected,
FIG. 4 is an exploded perspective view of a second embodiment,
FIG. 5 is a perspective view showing a state where a battery-side terminal and a harness-side terminal are connected,
FIG. 6 is an exploded perspective view of a third embodiment, and
FIG. 7 is a perspective view showing a state where a battery-side terminal and a harness-side terminal are connected.

Hereinafter, preferred embodiments of the present invention are described.

### - First Embodiment -

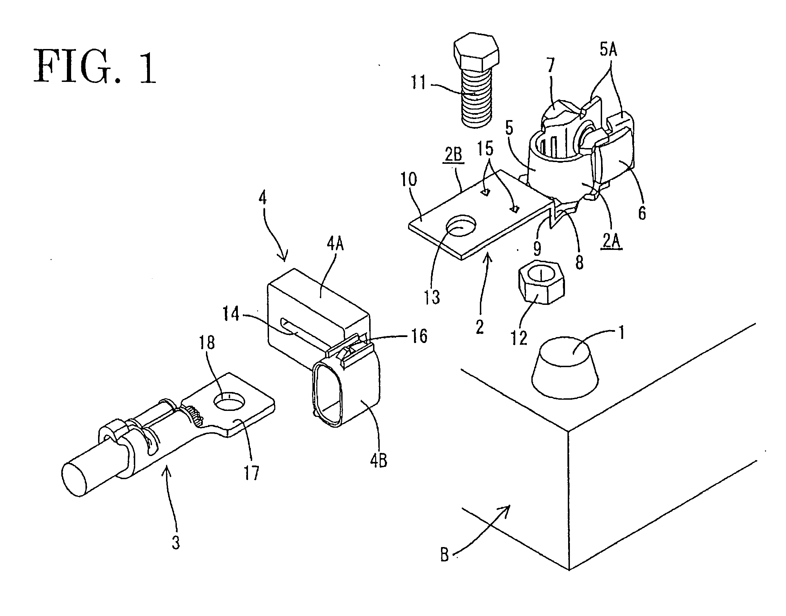

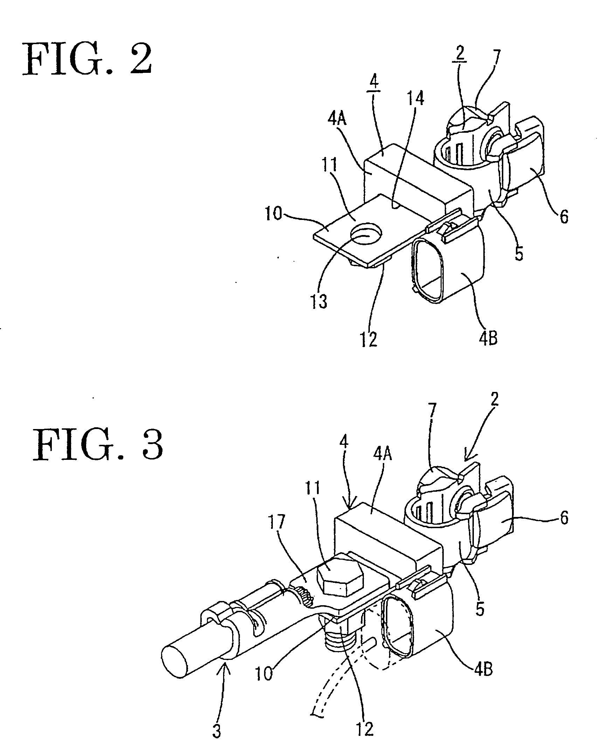

FIGS. 1 to 3 show a first embodiment of the present invention. In FIG. 1, identified by B is a battery mounted or mountable in an automotive vehicle, and a pair of battery posts 1 (lead electrodes) stand on the upper or first surface thereof (only one battery post is shown in FIG 1). Each battery post 1 is preferably in the formed of a truncated cone slightly tapered toward the top and a battery-side terminal 2 is to be connected therewith.

The battery-side terminal 2 is formed by bending an electrically conductive plate, and is comprised of a fastening portion 2A to be fastened to the battery post 1, and a mounting portion 2B for the mounting of a current sensor 4 and the connection with a harness-side terminal 3. The fastening portion 2A has a fastening ring 5 which can be fitted to or inserted over the battery post 1 from above or an insertion side. This fastening ring 5 is so curved as to form a substantially tubular shape which is opening upward and downward or along the fitting direction thereof, and its opposite ends extend sideways to oppose to each other, thereby forming substantially opposed walls 5A. A clamp bolt 6 for tightening the fastening ring 5 horizontally or laterally penetrates between and through the opposed walls 5A. This clamp bolt 6 has a rectangular head, which is engaged with the upper and lower edges of one of the opposed walls 5A to prevent further turning. A nut 7 is or can be engaged at an end of a shaft of the clamp bolt 6. The opposed walls 5A are or can be brought closer to each other by tightening the clamp bolt 6 and the nut 7, thereby tightening the fastening ring 5 to cause the fastening ring 5 to bite in the battery post 1.

The mounting portion 2B integrally or unitarily extends from the bottom edge of the fastening ring 5 substantially opposite from the opposed walls 5A. More specifically, a connecting piece 8 substantially horizontally or laterally extends from the fastening ring 5, the mounting portion 2B is bent upward at the leading end of the connecting piece 8 to form a stepped portion 9, and a mounting plate 10 continues via the stepped portion 9 to substantially horizontally or laterally extend. An insertion hole 13 for a bolt 11 which forms a fastening means together with a nut 12 is formed at a position of the mounting plate 10 toward its leading end.

The current sensor 4 is comprised of a sensor portion 4A having an unillustrated built-in detector (e.g. using a Hall device or the like) for detecting a current supplied from the battery B to loads connected with a wiring harness, and a connector portion 4B integrally or unitarily projecting from one side of the sensor portion 4A. The ring-shaped detector is preferably embedded in the sensor portion 4A by insert-molding e.g. of a synthetic resin, and a slit 14 for permitting insertion of the mounting plate 10 of the mounting portion 2B penetrates substantially in the center of the sensor portion 4A. In this embodiment, when the mounting plate 10 is inserted through the slit 14, a pair of mounting pieces which are provided by a pair of clasping pieces 15 formed on the upper surface of the connecting piece 8 e.g. by cutting and bending bite in the inner wall of the slit 14, thereby fixing the current sensor 4 to the battery-side terminal 2.

The connector portion 4B is integrally or unitarily molded with the sensor portion 4A so as to be continuous with the one side of the sensor portion 4A and has a substantially tubular shape which preferably is open at one side, and a terminal fitting connected with the aforementioned ring-shaped detector preferably is or can be mounted therein. The connector portion 4B is or can be fitted to a mating connector connected with an unillustrated current detecting circuit to enable a current measurement or detection, preferably by terminal fittings mounted inside being electrically connectable with each other. A locking claw 16 for holding the connector portion 4B connected with the mating connector projects from the upper surface of the connector portion 4B.

The harness-side terminal 3 has an existing construction and is or can be connected with a wire connected with an unillustrated load, and a coupling plate 17 preferably having substantially the same width as the mounting plate 10 of the battery-side terminal 2 is provided at its front side. The coupling plate 17 is formed with an insertion hole 18 which is substantially aligned with the insertion hole 13 when the coupling plate 17 and the mounting plate 10 are substantially aligned and placed one over the other.

The first embodiment is constructed as above. The current sensor 4 is fixed with the insertion hole 13 exposed by inserting the mounting plate 10 through the slit 14 and causing the clasping pieces 15 to bite in the inner wall surface of the slit 14. Then, the nut 12 is so fixed to the bottom surface of the mounting plate 10 preferably by welding as to conform to the insertion hole 13. In this way, the battery-side terminal 2 and the current sensor 4 are formed into one unit (or integrally mounted), which is then transported in this state to a connection site where it is to be connected with the battery post 1.

At the connection site, the fastening ring 5 of the battery-side terminal 2 is fitted to the battery post 1, and is tightened by tightening the clamp bolt 6, whereby the inner circumferential surface of the fastening ring 5 is reduced and fitted to or bites in the battery post 1. In this way, the battery-side terminal 2 is connected with the battery post 1. On the other hand, the coupling plate 17 of the harness-side terminal 3 is placed on the mounting plate 10 of the battery-side terminal 2 with the insertion holes 13, 18 substantially aligned with each other, and the bolt 11 is inserted through the holes 13, 18 and screwed into the nut 12 by, e.g. an impact wrench, whereby the battery-side terminal 2 and the harness-side terminal 3 are connected with each other. Finally, the connecting operation is completed by fitting the mating connector into the connector portion 4B of the current sensor 5.

A current flowing between the battery B and the load is or can be detected by the ring-shaped detector, and a degree of exhaustion of the battery can be judged based on a detected value.

As described above, according to this embodiment, the bolt 11 and the nut 12 are tightened at a position distanced from the battery post 1. Thus, the tightening operation can be smoothly performed using a tool at a place round the battery where there is a relatively sufficient empty space since nothing particularly hinders it. Further, since the current sensor 4 is transported to the connection site while being assembled with the battery-side terminal 2 instead of being mounted on the wiring harness, it can be more easily protected and/or mounted.

### - Second Embodiment -

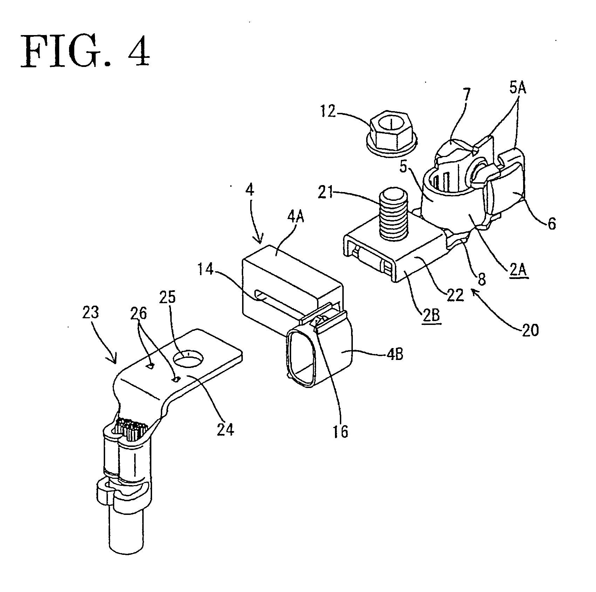

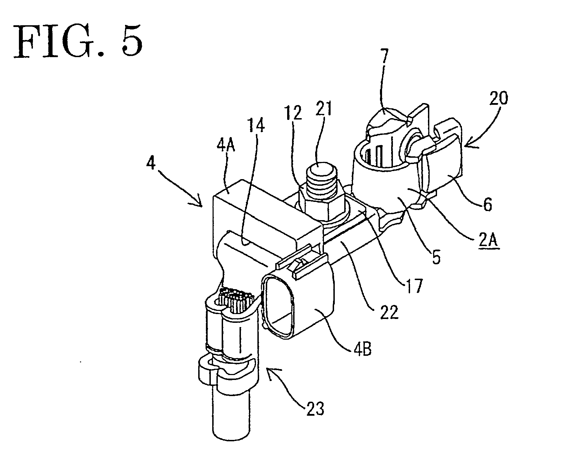

FIGS. 4 and 5 show a second embodiment of the present invention. The current sensor 4 of the second embodiment has the similar or same construction as that of the first embodiment, and a battery-side terminal 20 used has an existing construction. In other words, the battery-side terminal 20 used has a known construction in which a resting portion 22 with which a bolt 21 is or can be connected by welding and which forms part of the fastening means is provided instead of the mounting plate 10 of the first embodiment.

A harness-side terminal 23 has a coupling plate 24 which is longer than that of the first embodiment and is insertable into the slit 14 of the current sensor 4. A pair of mounting pieces 26 used to mount the current sensor 4 are formed behind an insertion hole 25 of the coupling plate 24 preferably by cutting and bending or embossing. Thus, when the coupling plate 24 is inserted through the slit 14 until the insertion hole 25 completely passes the slit 14, the mounting pieces 26 bite in or engage the inner wall of the slit 14, enabling mounting of the current sensor 4. The bolt 11 of the battery-side terminal 2 is insertable into the insertion hole 25 with the current sensor 4 thus mounted. Although the coupling plate 24 is bent down at its base portion in order to arrange a wire along one side surface of the battery B, it may be, unlike the shown example, left straight without being bent.

It should be noted that a method for fixing the current sensor 4 to the coupling plate 24 may be selected from various methods including adhesion and insert-molding.

With the second embodiment thus constructed, the battery-side terminal 20 and the current sensor 4 are separately transported to the connection site where the terminal 20 is connected with the battery post 1. At the connection site, the battery-side terminal 20 is first connected with the battery post 1 in such a manner as described above. Then, the coupling plate 24 of the harness-side terminal 23 is inserted through the slit 14 of the current sensor 4, the bolt 21 of the battery-side terminal 20 is inserted through the insertion hole 25 in this state, and the nut 12 is fastened to the bolt. In this way, the connecting operation is completed.

In the second embodiment, an existing terminal can be used as the battery-side terminal 2. Further, since the bolt 21 can be tightened at a position distanced from the battery B where nothing that hinders the tightening operation is around, the tightening operation is expected to be smoothly performed. Furthermore, since the current sensor 4 is first mounted prior to connection with the battery B instead of being connected with the wiring harness beforehand, there is no likelihood that it is broken while the wiring harness is handled.

### - Third Embodiment -

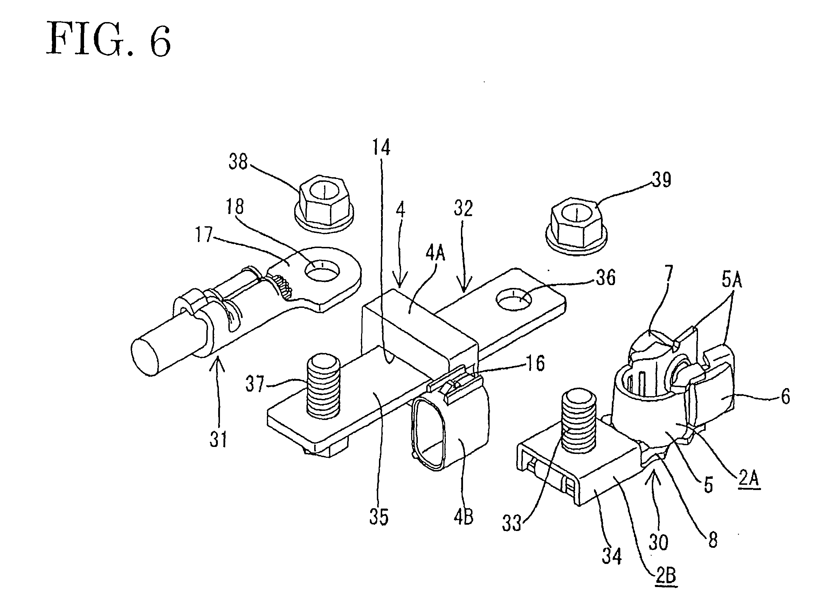

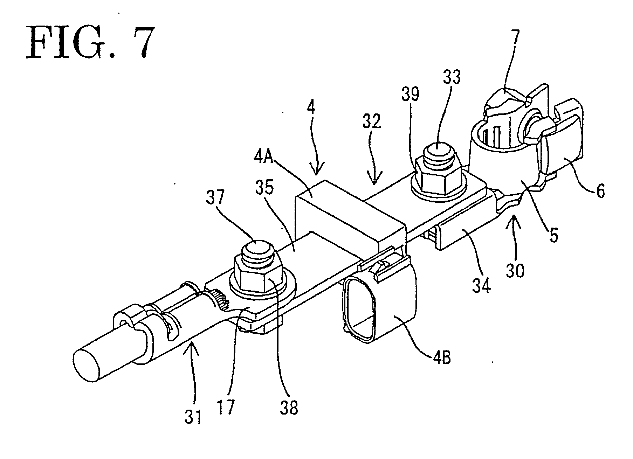

FIGS. 6 and 7 show a third embodiment, in which a battery-side terminal 30 and a harness-side terminal 31 are connected via a linking member 32.

The battery-side terminal 30 and the harness-side terminal 31 have both existing constructions: the harness-side terminal 31 has the same construction as that of the first embodiment and the battery-side terminal 30 is a terminal including a resting portion 34 provided with a bolt 33 as in the second embodiment.

The linking member 32 has a linking plate 35 made of a long piece of an electrically conductive metallic plate, and the current sensor 4 having the same construction as the first embodiment is mounted in the middle of this linking plate 35. Although the current sensor 4 is mounted on the linking plate 35 by causing projections preferably formed by cutting and bending or embossing as in the first and second embodiments to bite in, insert-molding, adhesion, and various other methods can also be considered as a mounting method.

A connection hole 36 for permitting insertion of the bolt 33 of the battery-side terminal 30 is formed at one end of the linking plate 35, and a connection bolt 37 is fixed at the other end by, e.g. welding (particularly need not be fixed) and is connectable with the harness-side terminal 31 by means of a nut 38. Accordingly, the bolt 33, the connection bolt 37 and the nuts 38, 39 corresponding thereto form fastening means.

The third embodiment thus constructed is assembled as follows. First, the bolt 33 of the battery-side terminal 30 is inserted through the connection hole 36 of the linking plate 35 and tightened by the nut 39 in order to assemble the linking member 32 having the current sensor 4 mounted thereon and the battery-side terminal 30 into one unit. In this way, the current sensor 4 is assembled with the battery-side terminal 30 together with the linking member 32, and this assembly is transported in this state to a connection site to be connected with the battery post 1.

At the connection site, the battery-side terminal 30 is connected with the battery post 1 in such a manner as described above. Then, the connection bolt 37 is inserted through the insertion hole 18 of the harness-side terminal 31 and is tightened by the nut 38, thereby connecting the harness-side terminal 31 and the linking member 32. In other words, the harness-side terminal 31 and the battery-side terminal 30 are connected via the linking member 32.

As described above, since the current sensor 4 is mounted on the linking member 32 and the harness-side terminal 31 and the battery-side terminal 30 are connected via the linking member 32 in the third embodiment, existing terminals can be used as the battery-side terminal 30 and the harness-side terminal 31. Further, since the current sensor 4 is transported to the connection site while being already mounted on the linking member 32 and the bolts can be tightened to connect the battery-side terminal 30 and the harness-side terminal 31 at a position distanced from the battery B where nothing that hinders the tightening operation is around, the tightening operation can be smoothly performed. Furthermore, since the current sensor 4 is not connected with the harness-side terminal 31, it can be protected as in the first and second embodiments.

Various changes can be made in the present invention, and following embodiments are also embraced by the present invention as defined in the claims.

Although the current sensor 4 shown is internally provided with the ring-shaped detector, the shape and mode thereof can be changed in various manners and are not limited to those of the foregoing embodiments.

## Claims

1. A battery terminal provided with a current sensor (4), comprising:
a battery-side terminal (2; 20; 30) to be connected with a battery post (1),
a harness-side terminal (3; 23; 31) to be connected with the leading end of a wire, preferably of a wiring harness, and
a fastening means (13, 11, 12; 21, 22; 33, 37-39) for enabling the both terminals (2, 3; 20, 23; 30, 31) to be disconnected from and connected with each other,
wherein the current sensor (4) is to be mounted at a connecting portion where the battery-side terminal (2; 20; 30) and the harness-side terminal (3; 23; 31) are to be connected;
**characterized in that**
the connecting portion is insertable into a slit (14) provided in the current sensor (4).

2. A battery terminal according to claim 1, wherein a mounting portion (2B) which serves as the connecting portion with the harness-side terminal (3) extends from the battery-side terminal (2), and the current sensor (4) is mountable on the mounting portion (2B) prior to connection of the both terminals (2, 3).

3. A battery terminal according to claim 1, wherein a linking member (32) which serves as the connecting portion is to be coupled by the fastening means (33, 37-39) and is provided between the battery-side terminal (30) and the harness-side terminal (31), and the current sensor (4) is to be mounted on the linking member (32 ).

4. A battery terminal according to claim 1, wherein a mounting portion (24) which serves as the connecting portion with the battery-side terminal (20) extends from the harness-side terminal (23), and the current sensor (4) is mountable on the mounting portion (24) prior to connection of the both terminals (20, 23).

5. A battery terminal according to one or more of the preceding claims, wherein the connecting portion is provided with one or more mounting pieces (15; 26) for connection with the current sensor (4).

6. A connector according to one or more of the preceding claims, wherein the battery-side terminal (2; 20; 30) is provided with a substantially clamp-like fastening portion (2A) to be fastened to the battery post (1).

## Patentansprüche

1. Batterieanschluß bzw. -klemme, ausgestattet mit einem Stormsensor (4), umfassend:
einen Batterie-seitigen Anschluß bzw. Klemme (2, 20; 30), welcher mit einem Batterieendpol (1) zu verbinden ist,
einen Kabelbaum-seitigen Anschluß bzw. Klemme (3; 23; 31), welcher mit dem vorderen Ende von einem Draht bzw. Kabel, bevorzugt von einem Kabelbaum, zu verbinden ist, und
ein Befestigungsmittel (13, 11, 12; 21, 22; 33, 37 - 39), um die beiden Anschlüsse (2, 3; 20, 23; 30, 31) voneinander trennen und miteinander verbinden zu können,
wobei der Stromsensor (4) an einem Verbindungsabschnitt zu montieren ist, wo der Batterie-seitige Anschluß (2; 20; 30) und der Kabelbaum-seitige Anschluß (3; 23; 31) zu verbinden sind;
**dadurch gekennzeichnet, daß**
der Verbindungsabschnitt in einen Schlitz (14) einsetzbar ist, welcher in dem Stromsensor (4) vorgesehen ist.

2. Batterieanschluß nach Anspruch 1, wobei ein Montageabschnitt (2B), welcher als Verbindungsabschnitt mit dem kabelbaum-seitigen Anschluß (3) dient, sich von dem Batterie-seitigen Anschluß (2) erstreckt, und der Stromsensor (4) ist vor der Verbindung der beiden Anschlüssen (2, 3) an dem Montageabschnitt (2B) montierbar.

3. Batterieanschluß nach Anspruch 1, wobei ein Verbindungs- bzw. Bindeglied (32), welches als Verbindungsabschnitt dient, durch die Befestigungsmittel (33, 37-39) zu koppeln ist und zwischen dem Batterie-seitigen Anschluß (30) und dem Kabelbaum-seitigen Anschluß (31) vorgesehen ist, und der Stromsensor (4) ist an dem Bindeglied (32) zu montieren.

4. Batterieanschluß nach Anspruch 1, wobei ein Montageabschnitt (24), welcher als Verbindungsabschnitt mit dem Batterie-seitigen Anschluß (20) dient, sich von dem Kabelbaum-seitigen Anschluß (23) erstreckt, und der Stromsensor (4) ist vor der Verbindung von den beiden Anschlüssen (20, 23) an dem Montageabschnitt (24) montierbar.

5. Batterieanschluß nach einem oder mehreren der vorangegangenen Ansprüche, wobei der Verbindungsabschnitt mit einer oder mehreren Montagestücken (15; 26) zur Verbindung mit dem Stromsensor (4) vorgesehen ist.

6. Verbinder nach einem oder mehreren der vorangegangenen Ansprüche, wobei der Batterie-seitige Anschluß (2; 20; 30) mit einem im wesentlichen klemmähnlichen Befestigungsabschnitt (2A) vorgesehen ist, um an dem Batterieendpol (1) befestigen zu sein.

## Revendications

1. Cosse de batterie équipée d'un mesureur de courant (4), comprenant :
une cosse côté batterie (2 ; 20 ; 30) à connecter à une borne de batterie (1),
une cosse côté câble (3 ; 23 ; 31) à connecter à l'extrémité de tête d'un câble, de préférence d'un faisceau de câblage, et
un moyen d'attache (13, 11, 12 ; 21, 22 ; 33, 37-39) pour permettre de déconnecter les deux cosses (2, 3 ; 20, 23 ; 30, 31) l'une de l'autre et de les connecter l'une à l'autre,
dans laquelle le mesureur de courant (4) doit être monté à l'endroit d'une partie de connexion où la cosse côté batterie (2 ; 20 ; 30) et la cosse côté câble (3 ; 23 ; 31) doivent être connectées,
**caractérisée en ce que**
la partie de connexion peut être insérée dans une fente (14) prévue dans le mesureur de courant (4).

2. Cosse de batterie selon la revendication 1, dans laquelle une partie de montage (2B) qui sert de partie de connexion avec la cosse côté câble (3) s'étend à partir de la cosse côté batterie (2), et le mesureur de courant (4) peut être monté sur la partie de montage (2B) avant la connexion des deux cosses (2, 3).

3. Cosse de batterie selon la revendication 1, dans laquelle un élément de liaison (32) qui sert de partie de connexion doit être couplé par le moyen d'attache (33, 37-39) et est prévu entre la cosse côté batterie (30) et la cosse côté câble (31), et le mesureur de courant (4) doit être monté sur l'élément de liaison (32).

4. Cosse de batterie selon la revendication 1, dans laquelle une partie de montage (24) qui sert de partie de connexion avec la cosse côté batterie (20) s'étend à partir de la cosse côté câble (23), et le mesureur de courant (4) peut être monté sur la partie de montage (24) avant la connexion des deux cosses (20, 23).

5. Cosse pour batterie selon une ou plusieurs des revendications précédentes, dans laquelle la partie de connexion comporte un ou plusieurs éléments de montage (15 ; 26) pour connexion avec le mesureur de courant (4).

6. Connecteur selon une ou plusieurs des revendications précédentes, dans lequel la cosse côté batterie (2 ; 20 ; 30) comporte une partie d'attache sensiblement en forme de pince (2A) pour attache à la borne de batterie (1).
